# Europäisches Patentamt
# European Patent Office
# Office européen des brevets

(11) Publication number: **0 112 622**
**B1**

(12) **EUROPEAN PATENT SPECIFICATION**

(45) Date of publication of patent specification: **27.12.89**

(51) Int. Cl.⁴: **G 06 F 11/10, G 06 F 11/00**

(21) Application number: **83306513.9**

(22) Date of filing: **26.10.83**

(54) Error correction in buffer storage units.

(30) Priority: **25.12.82 JP 231874/82**

(43) Date of publication of application:
**04.07.84 Bulletin 84/27**

(45) Publication of the grant of the patent:
**27.12.89 Bulletin 89/52**

(84) Designated Contracting States:
**DE FR GB**

(56) References cited:
**EP-A-0 039 227**
**GB-A-2 075 730**

**IBM TECHNICAL DISCLOSURE BULLETIN, vol.
20, no. 8, January 1978, pages 3187,3188, New
York, US; H. BARSUHN et al.: "Avoidance of soft
fail accumulation"**

The file contains technical information
submitted after the application was filed and
not included in this specification

(73) Proprietor: **FUJITSU LIMITED**
**1015, Kamikodanaka Nakahara-ku
Kawasaki-shi Kanagawa 211 (JP)**

(72) Inventor: **Matsumoto, Toshio**
**Gurin Haitsu 6 900-5, Mukaigaoka Miyamae-ku
Kawasaki-shi Kanagawa 213 (JP)**
Inventor: **Kato, Motokazu**
**1-5-10-42, Sobudai Danchi
Sagamihara-shi Kanagawa 228 (JP)**

(74) Representative: **Fane, Christopher Robin King
et al
HASELTINE LAKE & CO. Hazlitt House 28
Southampton Buildings Chancery Lane
London, WC2A 1AT (GB)**

(56) References cited:
**IBM TECHNICAL DISCLOSURE BULLETIN, vol.
22, no. 11, April 1980, pages 4931,4932, New
York, US; F.J. AICHELMANN Jr.: "Local paging
memory buffer for minimizing concurrence of
hard and soft data errors"**

Courier Press, Leamington Spa, England.

## Description

The present invention relates to error correction in buffer storage units, more particularly in a buffer storage unit of set-associative type provided in a data processing device having an error check and correct (EEC) function for single-bit error correction and plural-bit error detection.

Storage devices occasionally suffer from errors of data stored in their memory elements. These include bit-inversion errors produced by α-rays and so on, such errors being known as "soft errors" to distinguish them from "hard errors" caused by hardware disorders.

Soft errors can be corrected by rewriting the correct data into the memory elements. IBM Technical Disclosure Bulletin, Vol. 20, No. 8, January 1978, pages 3187 and 3188, in an article by Barsuhn et al, describes one such system. In some known storage devices, correction of soft errors has been effected by rewriting the error data by a patrol function or by rewriting the error data when otherwise writing part of the stored data into the storage device.

In the first method, it is necessary to access all the memory elements in the storage device. Thus, it takes a long time to correct the error data. In the second method, on the other hand, the error data can be corrected only at the time of partial writing and cannot be corrected at the time of reading.

In the latter case, the read-out data can be corrected by the ECC function, thus there is no trouble in the processing of the read-out data. The error data, however, remains stored in the storage device. Thus, every time a read command for an address in which there is a single bit error is executed by the buffer storage unit of the storage device, a machine-check interrupt for a single-bit error is generated.

If such machine check interrupts are produced more than a predetermined number of times during a certain time interval, the software control shuts off the control mask for the system recovery (SR) interrupt and enters a quiet mode in which the SR class machine check interrupt is not accepted.

SR class machine check interrupts, however, include not only correction of single-bit errors, but also the success of command retries, etc. As it is not desirable that the unit enter the quiet mode too easily, the second method can be disadvantageous when data with a single-bit error in the buffer storage unit is accessed frequently in a short time.

It is therefore desirable to provide a system for treatment of single-bit errors in a buffer storage unit in which the unit is prevented from readily entering the quiet mode due to frequent machine check interrupts generated by successively accessing data containing a single bit error.

The system for treatment of single-bit error in a buffer storage unit in accordance with the invention is adapted for use with a data processing device comprising: a main storage unit; a buffer storage unit holding a portion of the data stored in the main storage unit in a set-associative manner; and an ECC portion functioning to check and correct single-bit error and to check plural-bit error; the data stored in the buffer storage unit being replaceable with data in the main storage unit in N (more than 1) ways.

The system comprises means for holding an address for which data read out from the buffer storage unit is found to contain a single-bit error and a means for generating an address for the main storage unit. When a single-bit error is detected in the data read out from the buffer storage unit, the main storage addresses corresponding to the "SET" (memory sector) of the buffer storage unit, which SET holds the data containing the single bit error, are generated by the memory address generating means a predetermined number of times. The data held in the SET of the buffer storage unit including the data containing the single-bit error is moved out from the buffer storage unit. The data containing the single-bit error is thereupon checked and corrected in the ECC portion, and the corrected data is stored in the main storage unit.

Reference will now be made, by way of example, to the accompanying drawings, in which:

Figure 1 is a block diagram of a system for treatment of single-bit error in a buffer storage unit in accordance with one embodiment of the present invention, and

Figs. 2A, 2B and 2C illustrate memory structures of an error data address register, the buffer storage unit, and the main storage unit, respectively.

Before describing the preferred embodiments, the principle of the present invention will be described in brief.

In a data processing device comprising a main storage unit and comprising a buffer storage unit holding the data stored in the main storage unit in a set-associative manner, when the data held in the buffer storage unit is replaced with other data stored in the main storage unit, the data moved out from the buffer storage unit is stored in the main storage unit through an ECC portion. If the data moved out from the buffer storage unit contains a single-bit error, the ECC portion corrects the error data, and the data corrected by the ECC portion is stored in the main storage unit.

Accordingly, when single-bit error is detected in data read out from the buffer storage unit in response to an ordinary memory access, the data held in the buffer storage unit may be forcibly replaced by generating the address of data having the same set address as the error data and not held in the buffer storage unit and by accessing the address. When the data to be sent back to the main storage unit contains a single-bit error, it is connected by the ECC portion before storage in the main storage unit.

Therefore, if all the data in a set including the data having the single-bit error are moved out from the buffer storage unit to the main storage unit by generating a necessary number of addresses, the data having the single bit error is also moved out from the buffer storage unit. Since this one-bit error is corrected in the ECC portion and the corrected data is stored in the main storage unit, when this data in the main storage unit is again replaced for some data in the buffer storage units by another normal access, the data held in the buffer storage unit will be corrected.

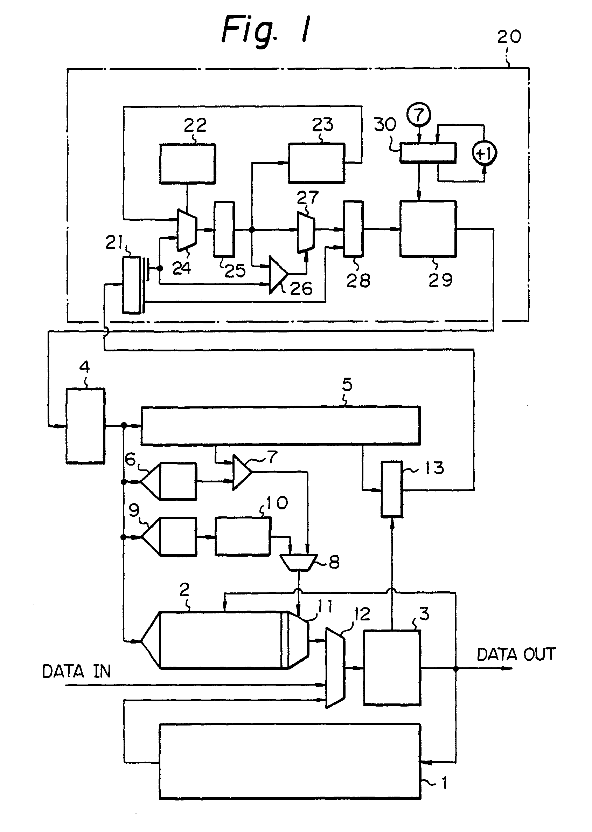

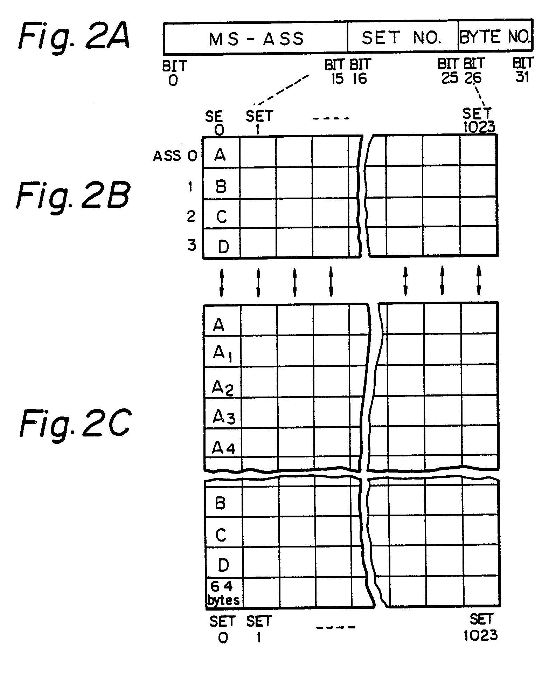

A system for treatment of single-bit error in a buffer storage unit in accordance with one embodiment of the present invention will be described in detail with reference to Figs. 1 and 2. Figure 1 is a block diagram of the above-mentioned system. Figures 2A, 2B, and 2C illustrate memory structures of an error data address register, the buffer storage unit, and the main storage unit, respectively.

In Fig. 1, 1 is a main storage unit, 2 is a buffer storage unit, 3 is an ECC portion, 4 is a control address portion, 5 is a pipeline processing portion, 6 is a tag portion, 7 is a comparator, 8 is a decoder, 9 is a "least recently used" (LRU) judging portion, 10 is a replace instruction portion, 11 is a data selector, 12 is a data line selector, 13 is an error data address register, 20 is a central processing unit (CPU), 21 is an error data address register, 22 is a fetch address control portion, 23 is a fetch address generating portion, 24 is a selector, 25 is a first address register, 26 is a comparator, 27 is a gate circuit, 28 is a second address register, 29 is a fetch request control portion, and 30 is a down counter.

In the main storage unit 1, various data necessary for data processing are stored. The main storage unit 1 has a set-structure as shown in Fig. 2C, for example, from SET 0 to SET 1023, each block having 64 bytes of data.

The buffer storage unit 2 is used for holding a portion of the data stored in the main storage unit 1 for its access operation. The buffer storage unit 2 has the same set structure from SET 0 to SET 1023 as the main storage unit 1, each SET having four blocks. In the buffer storage unit 2, the data is held in a set-associative manner, in which the data stored in the main storage unit 1 is held in a block having the same SET number as in the buffer storage unit 2.

The ECC portion 3 is used for checking and correcting single-bit errors in the data output from the buffer storage unit 2, the input data (DATA IN) from the CPU 20, and the read-out data from the main storage unit 1, and for checking plural bit errors in the data output from the buffer storage unit 2, the input data (DATA IN), from the CPU 20, and the read-out data from the main storage unit 1. The control address portion 4 is used for outputting the address necessary for the data processing. The pipeline processing portion 5 is used for holding the address necessary for judging whether the necessary access data exists in the buffer storage unit 2 or whether the data read out from the buffer storage unit 2 contains single-bit error and for outputting the address to the predetermined portions in the predetermined timing in a pipeline manner.

The tag portion 6 is used for holding the block number in the main storage unit 1 of the data stored in the buffer storage unit 2 in order to judge whether the access data is held in the buffer storage unit 2. The LRU judging portion 9 is used for judging the order of the blocks in each SET, i.e., which block is accessed least recently, in order to determine the block to be replaced when a block not held in the buffer storage unit 2 is accessed. The replace instruction portion 10 is used for controlling the selection of the data to be replaced by the instruction from the LRU judging portion 9 when the replacement is required.

The data selector 11 is used for selecting a particular block from the four blocks of data in each SET output from the buffer storage unit 2. The data line selector 12 is used for selecting the data to be supplied to the ECC portion 3 among the output data from the data selector 11, the input data, and the data output from the main storage unit 1.

The fetch address generating portion 23 is used for generating address data having the same SET number as the SET holding the data containing the single-bit error in order to correct any detected single-bit error. For example, when the buffer storage unit 2 has a four-block structure for each SET and block A in SET 0 contains a single-bit error, as shown in Fig. 2B, the fetch address generating portion 23 generates the addresses of the block having the same SET number as the block A but not held in the buffer storage unit 2, for example, $A_1$ to $A_4$ as shown in Fig. 2C. If the four blocks $A_1$ through $A_4$ following block A are not held in the buffer storage unit 2, block A can be reliably replaced by generating and accessing these four addresses $A_1$ through $A_4$ successively.

The address of each data stored in the main storage unit 1 has the bit structure as shown in Fig. 2A. The initial 16 bits BIT 0 through BIT 15 indicate the block address number MS-ASS, the following 10 bits BIT 16 through BIT 25 indicate the SET address number, and the last 6 bits BIT 26 through BIT 31 indicate the byte number in each block. Thus, the successive four blocks $A_1$ through $A_4$ can be generated by changing the preceding 16 bits BIT 0 through BIT 15 successively.

If any of the four blocks $A_1$ through $A_4$ is held in the buffer storage unit 2, however, the required replacement may not be effected by generating the four block addresses. Thus, in order to reliably replace the data having the single-bit error of the buffer storage unit 2, it is necessary to generate and access at least seven different block addresses having the same SET number as the data containing the single bit error.

The fetch request control portion 29 is used for generate an access request to the main storage unit 1 in accordance with the data addresses output from the fetch address generating portion 23. The down counter 30 is used for counting the number of access requests generated up to the required number, that is, seven in the above-mentioned example.

The operation of the above-mentioned system for treatment of single bit error will now be described with reference to the accompanying drawings.

When accessing the data necessary for data processing to the main storage unit 1, the access data address is supplied to the control address portion 4 through a route not shown in Fig. 1 and then supplied to the pipeline processing portion 5 and to the tag portion 6. If the required data exists in the buffer storage unit 2, the block number output from the pipeline processing portion 5 and the block number output from the tag portion 6, which are compared in the comparator 7, become equal, and the equal block number is decoded by the decoder 8. The output of the decoder 8 is supplied to the data selector 11, and the data of the equal block number is selected among the data of the same SET number output from the buffer storage unit 2. The selected data is supplied to the ECC portion 3 through the data line selector 12 and is checked by the ECC portion 3. If no error exists in the checked data, the data is output.

On the other hand, if the check shows that a single-bit error exists, the ECC portion 3 corrects the error data and outputs the corrected data to the data request source. At the same time, the ECC portion 3 outputs a control signal to the error address register 13. The error address register 13 sets the address of the data containing the single bit error, which address is supplied from the pipeline processing portion 5. The error address register 13 also sets a one-bit error indication.

The address data set in the error address register 13 is supplied to the CPU 20 and set into the error address register 21 of the CPU 20. At this time, the control for single-bit error correction processing is started in the CPU 20.

In the CPU 20, the fetch address control portion 22 starts to operate and controls the selector 24 to pass the MSB 16 bits of the error address register 21 to the first address register 25. The first address register 25 sets the MSB 16 bits, which corresponds to the block number. The 16 bit data set in the first address register 25 is supplied to the fetch address generating portion 23, the comparator 26, and the gate circuit 27. In the comparator 26, the 16 bit data from the first address register 25 is compared with the MSB 16 bits of the error address register 21. At first, they are equal. In this case, the comparator 26 turns the gate circuit 27 off.

Then, the fetch address generating portion 23 increments the 16 bit data by +1. The incremented 16 bit data is supplied to the first address register 25 through the selector 24 and set into the first address register 25. Then, the data from the first address register 25 is compared with the MSB 16 bits of the error address register 21 in the comparator 26. In this case, they are not equal. Thus, the comparator 26 turns the gate circuit 27 on so as to pass the 16 bit data to the second address register 28. The address data except the MSB 16 bits from the error address register 21 is also supplied to the second address register 28. The address data formed by combining these two data is set into the second address register 28. Then, the address data from the second address register 28 is supplied to the fetch request control portion 29. The fetch request control portion 29 outputs an access request for the main storage unit 1. This access request is also supplied to the control address portion 4.

The control address portion 4 starts to operate in response to the access request. The access address is compared with the address from the tag portion 6 in the comparator 7. In the case where none of the addresses in the tag portion 6 are equal to the access address, the replace instruction portion 10 moves out the block instructed by the LRU judging portion 9 from the buffer storage unit 2, then reads out the block of the accessed address from the main storage unit 1. The block is then held in the buffer storage unit 2. At this time, the data moved out from the buffer storage unit 2 is checked in the ECC portion 3, corrected if it contains a single-bit error, then stored in the main storage unit 1.

The 16 bit data in the fetch address generating portion 23 is then incremented by +1, and the new address is generated by it. The access operation described above is repeated for the new address.

As described above, if no block held in the same SET of the buffer storage unit 2 has the same block number as the accessed address, one of the four blocks in the same SET is moved out from the buffer storage unit 2 every time the new address is generated and accessed. Thus, in the buffer storage unit having the structure as shown in Fig. 2B, by generating and accessing four addresses successively, the block containing the single bit error data can be moved out from the buffer storage unit 2, corrected in the ECC portion 3, and stored in the main storage unit 1. Therefore, if this block is read out from the main storage unit 1 at the next access time, the correct data of this block can be held in the buffer storage unit 2. After replacing the data containing the single-bit error from the buffer storage unit 2 as described above, a machine check interrupt is generated for the software, and the processing is completed.

The down counter 30 may be used for controlling the number of the addresses generated by the fetch address generating portion 23. A predetermined number is preset in the down counter 30. Each time a new address is generated by the fetch address generating portion 23 the down counter 30 is decremented by −1. When the down counter 30 becomes zero, the access operation is completed. The predetermined number is selected to ensure that the data containing the single-bit error is moved out from the buffer storage unit 2 without fail. In the above mentioned type of buffer storage unit, the number selected is 7.

Of course, the required number of data replacements may be changed in accordance with the memory structure of the buffer storage unit. Thus, it may be constructed such that the number of the data replacement can be selected according to the condition of the data processing.

In the system described above, when a single-bit error is detected in the buffer storage unit, an interrupt is first generated for the firmware without generating a machine check interrupt for the software, then the firmware control recognizes that the cause of the interrupt is single-bit error, reads out the address of the error data, and carries out the above-mentioned processing.

When a single-bit error is detected in a buffer storage unit in which N ways of replacement of data is possible, data containing a single-bit error can be corrected by accessing the addresses in the same SET as the error data at least N times. Therefore, even if this data is accessed in succession, it is prevented from frequently generating machine check interrupts, allowing the data processing to be carried out efficiently.

**Claims**

1. A data processing system comprising:—
a main storage (1) for storing data;
a buffer storage (2) for storing an image of a portion of the data in the main storage (1) in a set-associative manner, the buffer storage (2) having a plurality of associative ways (ASS 0 to ASS 3) per set (SET 0 to SET 1023), transfer of data between main and buffer storage being carried out such that, when the data corresponding to an address in respect of which an access request occurs does not exist in the buffer storage (2), data in one of the ways in the relevant set of the buffer storage (2) is transferred from that way to main storage (1) and data corresonding to the access request address is transferred to that way from main storage (1), data read from the buffer storage (2) being used for processing after errors in the read-out data are corrected, without restoring corrected data to the buffer storage; and
error check and correct (ECC) means (3) operable to carry out single-bit error correction and two-bit error detection in relation to data being transferred from the buffer storage (2) to the main storage (1);
characterised in that:
the system further comprises means (13, 21 to 30), operable in response to an error in data read-out from the buffer storage (2), to cause transfer of data, including the erroneous data, from buffer storage (2) to the main storage (1), the erroneous data being corrected by the error check and correct means (3) during that transfer, and the thus corrected data being stored into the main storage (1).

2. A system according to claim 1, wherein said transfer means comprises:—
address holding means (13, 21) operable to hold the address in respect of which an access request leads to read-out of erroneous data; and
access request generating means (22 to 30) operable to generate access requests for a predetermined number of different addresses, each relating to the set including the erroneous data, on the basis of the address held in the address holding means (13, 21), to cause transfer of the erroneous data from buffer storage (2) to main storage (1).

3. A system according to claim 2, wherein the said predetermined number is equal to or greater than 2n-1, where the number of ways of the buffer storage (2) is N.

4. A system as claimed in claim 2 or 3, wherein the access request generating means (22 to 30) employs a down counter (30) to generate the said predetermined number of addresses.

5. A system as claimed in any preceding claim, wherein when the data corresponding to an address in respect of which an access request occurs does not exist in the buffer storage (2), data in one of the ways in the relevant set of buffer storage (2) is transferred from that way to main storage (1), the way being selected using least-recently-used (LRU) logic.

**Patentansprüche**

1. Datenverarbeitungssystem mit:—
einem Hauptspeicher (1) zum Speichern von Daten:
einem Pufferspeicher (2) zum Speichern eines Bildes eines Abschnitts der Daten in dem Hauptspeicher (1) in einer satz-assoziativen Weise, welcher Pufferspeicher (2) eine Vielzahl von assoziativen Wegen (ASS 0 bis ASS 3) pro Satz (SET 0 bis SET 1023) hat, wobei der Transfer von Daten zwischen Haupt- und Pufferspeicher derart ausgeführt wird, daß dann, wenn die Daten, die einer Adresse entsprechen, in Bezug auf welcher eine Zugriffsanforderung auftritt, nicht in dem Pufferspeicher (2) existieren, Daten auf einem der Wege in dem relevanten Satz des Pufferspeichers (2) von jenem Weg zu dem Hauptspeicher (1) übertragen werden, und Daten, die der Zugriffsanforderungsadresse entsprechen, zu jenem Weg von dem Hauptspeicher (1) übertragen werden, Daten, die von dem Pufferspeicher (2) ausgelesen werden, zur Verarbeitung verwendet werden, nachdem Fehler in den ausgelesenen Daten korrigiert sind, ohne korrigierte Daten zu dem Hauptpuffer wiederherzustellen; und
eine Fehlerprüf- und Korrektur-(ECC)-Einrichtung (3), die betreibbar ist, um eine Ein-Bit-Fehlerkorrektur und eine Zwei-Bit-Fehlerdetektion in Relation zu Daten durchzuführen, die von dem Pufferspeicher (2) zu dem Hauptspeicher (1) übertragen werden;
dadurch gekennzeichnet, daß
das System ferner Einrichtungen (13, 21 bis 30) umfaßt, die in Abhängigkeit von einem Fehler in den von dem Pufferspeicher (2) ausgelesenen Daten betreibbar sind, um einen Transfer von Daten zu bewirken, einschließlich der fehlerhaften Daten, von dem Pufferspeicher (2) zu dem Hauptspeicher (1), wobei die fehlerhaften Daten durch die Fehlerprüf- und Korrektureinrichtung (3) während jenes Transfers korrigiert werden, und die so korrigierten Daten in den Hauptspeicher (1) gespeichert werden.

2. System nach Anspruch 1, bei dem die genannte Transfereinrichtung umfaßt:—

Adreßhalteeinrichtungen (13, 21), die betreibbar sind, um die Adresse zu halten, in Bezug auf welche eine Zugriffsanforderung zum Auslesen von fehlerhaften Daten führt; und

Zugriffsanforderungsgeneratoreinrichtungen (22 bis 30), die betreibbar sind, um Zugriffsanforderungen für eine vorbestimmte Anzahl von verschiedenen Adressen zu erzeugen, von denen jede sich auf den die fehlerhaften Daten enthaltenden Satz bezieht, auf der Basis der Adresse, die in der Adreßhalteeinrichtung (13, 21) gehalten wird, um einen Transfer von den fehlerhaften Daten von dem Pufferspeicher (2) zu dem Hauptspeicher (1) zu bewirken.

3. System nach Anspruch 2, bei dem die genannte vorbestimmte Zahl gleich oder größer als 2N-1 ist, wobei die Zahl der Wege von dem Pufferspeicher (2) N ist.

4. System nach Anspruch 2 oder 3, bei dem die Zugriffsanforderungsgeneratoreinrichtung (22 bis 30) einen Abwärtszähler (30) verwendet, um die genannte vorbestimmte Anzahl von Adressen zu generieren.

5. System nach einem der vorhergehenden Ansprüche, bei dem dann, wenn die Daten, die einer Adresse entsprechen, in Bezug auf welche eine Zugriffsanforderung auftritt, nicht in dem Pufferspeicher (2) existieren, Daten auf einem der Wege in dem relevanten Satz des Pufferspeichers (2) von jenem Weg zu dem Hauptspeicher (1) transferiert werden, wobei der Weg unter nach Verwendung der "am längsten nicht benutzt"-(LRU) Logik ausgewählt wird.

## Revendications

1. Système de traitement de données comprenant:

une mémoire centrale (1) pour mémoriser des données;

une mémoire tampon (2) pour mémoriser une image d'une partie des données de la mémoire centrale (1) d'une manière à secteurs associatifs, la mémoire tampon (2) comportant un ensemble de voies associatives (ASS 0 à ASS 3) par secteur (SECTEUR 0 à SECTEUR 1023), le transfert de données entre la mémoire centrale et la mémoire tampon étant exécuté de telle sorte que, lorsque les données correspondant à une adresse par rapport à laquelle une demande d'accès se produit ne se trouvent pas dans la mémoir tampon (2), les données dans une des voies du secteur concerné de la mémoire tampon (2) sont transférées de cette voie jusqu'à la mémoire centrale (1) et les données correspondant à l'adresse de demande d'accès sont transférées jusqu'à cette voie à partir de la mémoire centrale (1), les données lues dans la mémoire tampon (2) étant utilisées pour un traitement après que les erreurs contenues dans les données lues aient été corrigées, sans rétablir les données corrigées dans la mémoire tampon; et

un moyen de contrôle et de correction d'erreurs (ECC) (3) pouvant être mis en fonctionnement pour exécuter une correction d'erreur portant sur un seul bit et une détection d'erreur portant sur deux bits en rapport avec les données qui sont transférées de la mémoire tampon (2) jusqu'à la mémoir centrale (1);

caractérisé en ce que

le système comprend en outre un moyen (13, 21 à 30), pouvant être mis en fonctionnement en réponse à une erreur dans les données lues dans la mémoire tampon (2), pour produire un transfert de données, y compris les données erronées, de la mémoire tampon (2) à la mémoire centrale (1), les données erronées étant corrigées par le moyen de contrôle et de correction d'erreurs (3) pendant ce transfert, et les données ainsi corrigées étant mémorisées dans la mémoire centrale (1).

2. Système selon la revendication 1, dans lequel le moyen de transfert comprend:

un moyen de maintien d'adresse (13, 21) pouvant être mis en fonctionnement pour maintenir l'adresse par rapport à laquelle une demande d'accès conduit à la lecture de données erronées; et

un moyen générateur de demande d'accès (22, à 30) pouvant être mis en fonctionnement pour générer des demandes d'accès pour un nombre prédéterminé d'adresses différentes, chacune étant relative au secteur incluant les données erronées, en fonction de l'adresse maintenue dans le moyen de maintien d'adresse (13, 21), pour produire le transfert des données erronées de la mémoire tampon (2) à la mémoire centrale (1).

3. Système selon la revendication 2, dans lequel le nombre prédéterminé est égal à ou supérieur à 2N-1, où le nombre de voies de la mémoire tampon (2) est égal à N.

4. Système selon l'une quelconque des revendications 2 et 3, dans lequel le moyen générateur de demande d'accès (22 à 30) met en oeuvre un compteur régressif (30) pour générer le nombre prédéterminé d'adresses.

5. Système selon l'une quelconque des revendications 1 à 4, dans lequel, quand les données correspondant à une adresse par rapport à laquelle une demande d'accès a lieu ne se trouvent pas dans la mémoire tampon (2), les données dans une des voies dans le secteur concerné de la mémoire tampon (2) sont transférées de cette vois jusqu'à la mémoire centrale (1), la voie étant sélectionnée en mettant en oeuvre un moyen logique de décision du moins récemment utilisé (LRU).

EP 0 112 622 B1

# Fig. 1

DATA IN

DATA OUT

Fig. 2A

Fig. 2B

Fig. 2C